# EUROPEAN PATENT SPECIFICATION

(11) **EP 3 807 553 B1**
(45) Date of publication and mention of the grant of the patent: **11.11.2026**
(21) Application number: 19735012.7
(22) Date of filing: 13.06.2019
(51) Int. Cl.: F16F 1/02, F16F 15/073

(54) **VIBRATION ISOLATION SYSTEM WITH THERMAL GROWTH COMPENSATION**
SCHWINGUNGSISOLATIONSSYSTEM MIT THERMISCHER WACHSTUMSKOMPENSATION
SYSTÈME ANTIVIBRATIONS À COMPENSATION DE LA CROISSANCE THERMIQUE

(30) Priority: 13.06.2018 US 201862684300 P
(43) Date of publication of application: 21.04.2021
(73) Proprietor: Raytheon Company, Waltham, Massachusetts 02451-1449 (US)
(72) Inventor: FORGACS, Stephen J., Tucson, Arizona 85748 (US); BERGMANN, Bradley E., Tucson, Arizona 85748 (US); KOSINSKI, Nicholas E., Tucson, Arizona 85704 (US)
(74) Representative: Crowell & Moring U.K. LLP
(86) International application number: PCT/US2019/036935
(87) International publication number: WO 2019/241494

(56) References cited:
- EP-A1- 3 147 536
- DE-A1- 102015 011 224
- US-A- 5 769 381
- US-A1- 2014 234 100
- US-B1- 6 264 179

## Description

### FIELD OF THE INVENTION

The invention is in the field of vibration isolation.

### DESCRIPTION OF THE RELATED ART

In some situations dynamic isolation is desirable to reduce potential damaging frequency content to critical components. Specific applications experiencing large thermal gradients results in either ineffective isolation or failure of the isolation member due to increase stress. This problem has not been satisfactorily addressed.

DE 10 2015 011224 A1 discloses a spring element, which is to be mounted between a structural part and a component and which has a supporting plate-shaped base body which is interrupted by at least one recess, is characterized in that the spring element has an end face fastening section which extends over the end face of the spring element and is used for fastening to the structural part, an end fastening section which extends over the end side of the spring element for fastening to the component, and comprises two lateral legs which extend laterally from the front fastening section to the end fastening section, with a substantially parallelogram-shaped recess formed between the front fastening section, the end fastening section and the legs.

US 6 264 179 B1 discloses a seat assembly comprising a generally rectangular frame, a center rail, a plurality of modular springs secured to the frame and a wire grid secured to the modular springs. Each of the modular springs has a front section secured to the front rail of the rectangular frame, a resilient center section secured to the center rail and a rear section spaced above the frame and unattached to any of the rails. The front section of each modular spring is preloaded to increase the resilient support of the seat.

EP 3 147 536 A1 discloses an antivibration device which can enhance the antivibration characteristic in the horizontal direction is provided. An antivibration device includes: a support part supported by at least one first viscoelastic body so as to permit circumferential movement; a carrying part to which a target object for antivibration is mounted; a connecting mechanism connecting the support part with the carrying part; wherein the connecting mechanism has at least one second viscoelastic body which permits the circumferential movement of the carrying part with respect to the support part. Preferably, the connecting mechanism further includes a suspending plate suspending the carrying part; wherein the suspending plate is supported by at least one of the second viscoelastic bodies from the lower side in the gravitational direction.

US 5 769 381 A1 discloses a process for preventing vibrations of a shaft driven into rotation around its axis and having a length greater than its diameter. The shaft is maintained at both ends by fixed centering devices and at its center by at least one intermediate support. The support is located on one side of the shaft, and its position with respect to the end centering devices is adjusted so that, in its central part, the center of the shaft is away from the line running through the centers of the end centering devices on the side opposite the intermediate support. The shaft is thus subjected to permanent deformation and maintained applied onto rolling bearing devices by an elastic recall force.

### SUMMARY OF THE INVENTION

A vibration isolation system includes isolators that allow for displacement between an object to be isolated, and a housing, frame, or other structure that encounters vibrations or shocks from which the object is to be isolated.

A vibration isolation system includes isolators that slide, allowing for relative displacement in a longitudinal direction.

A vibration isolation system includes isolators capable of expanding, to accommodate relative displacement in a radial direction.

A vibration isolation system includes both single-piece isolators with flexures, and multi-piece isolators.

A vibration isolation system that is part of a missile includes isolators with the ability to compensate for expansion of a fuselage of the missile by heating.

According to the invention, there is provided a vibration isolator according to appended claim 1.

There is disclosed herein a vibration isolation system comprising: an outer housing; an inner object within the outer housing; and multiple isolators between the inner object and the outer housing; wherein each of the multiple isolators includes a flexure; and wherein some of the isolators include an expander or expansion mechanism to compensate for changes in distance between the inner object and the outer housing.

According to an embodiment of any paragraph(s) of this summary, the outer housing is part of a missile.

According to an embodiment of any paragraph(s) of this summary, the inner object is a hardware mount.

According to an embodiment of any paragraph(s) of this summary, the system further includes equipment in the hardware mount.

According to an embodiment of any paragraph(s) of this summary, the system further includes electronic cards, devices, or elements in the hardware mount.

According to an embodiment of any paragraph(s) of this summary, at least some of the isolators are single-piece isolators.

According to an embodiment of any paragraph(s) of this summary, at least some of the isolators are multi-part isolators, able to change length.

According to an embodiment of any paragraph(s) of this summary, at least some of the isolators slide relative to one of the outer housing or the inner object.

According to an embodiment of any paragraph(s) of this summary, at least some of the isolators slide relative to one of the outer housing or the inner object in a longitudinal direction.

According to an embodiment of any paragraph(s) of this summary, at least some of the isolators slide relative to the outer housing, such as in a longitudinal direction.

According to an embodiment of any paragraph(s) of this summary, at least some of the isolators are multi-part isolators that each include: an inner isolator part; an outer isolator part; a wedge element; and at least one spring.

According to an embodiment of any paragraph(s) of this summary, one of the isolator parts has a flexure; and the at least one spring provides a force on the wedge element to provide a force separating the inner isolator part and the outer isolator part.

According to an embodiment of any paragraph(s) of this summary, the flexure is in the outer isolation part.

According to an embodiment of any paragraph(s) of this summary, the parts have respective sloped surfaces that together define a channel that receives a wedge portion of the wedge element.

According to an embodiment of any paragraph(s) of this summary, the at least one spring includes a pair of springs pulling on opposite sides of the wedge element.

According to an embodiment of any paragraph(s) of this summary, the wedge portion has a wedge angle of between 10 and 20 degrees.

According to an embodiment of any paragraph(s) of this summary, the wedge portion has a wedge angle of 15 degrees.

According to an embodiment of any paragraph(s) of this summary, the isolators that slide slide in a first direction; and the some of the isolators expand in a second direction that is perpendicular to the first direction.

According to an embodiment of any paragraph(s) of this summary, the first direction is a longitudinal direction.

According to an embodiment of any paragraph(s) of this summary, the isolators that slide slide against contact pads.

According to an embodiment of any paragraph(s) of this summary, the flexures are S-shape flexures.

According to an embodiment of any paragraph(s) of this summary, middle portions of the S-shape flexures have different orientations for some of the S-shape flexures than for other of the S-shape flexures.

There is disclosed herein a vibration isolator comprising all the features of the independent claim 1.

To the accomplishment of the foregoing and related ends, the invention comprises the features hereinafter fully described and particularly pointed out in the claims. The following description and the annexed drawings set forth in detail certain illustrative embodiments of the invention. These embodiments are indicative, however, of but a few of the various ways in which the principles of the invention may be employed. Other objects, advantages and novel features of the invention will become apparent from the following detailed description of the invention when considered in conjunction with the drawings.

### BRIEF DESCRIPTION OF THE DRAWINGS

The annexed drawings, which are not necessarily to scale, show various aspects of the invention.

According to an embodiment of any paragraph(s) of this summary, one of the isolator parts has a flexure; and the at least one spring provides a force on the wedge element to provide a force separating the inner isolator part and the outer isolator part.

According to an embodiment of any paragraph(s) of this summary, the flexure is in the outer isolation part.

According to an embodiment of any paragraph(s) of this summary, the at least one spring includes a pair of springs pulling on opposite sides of the wedge element.

According to an embodiment of any paragraph(s) of this summary, the wedge portion has a wedge angle of between 10 and 20 degrees.

According to an embodiment of any paragraph(s) of this summary, the wedge portion has a wedge angle of 15 degrees.

According to an embodiment of any paragraph(s) of this summary, the isolators that slide slide in a first direction; and the some of the isolators expand in a second direction that is perpendicular to the first direction.

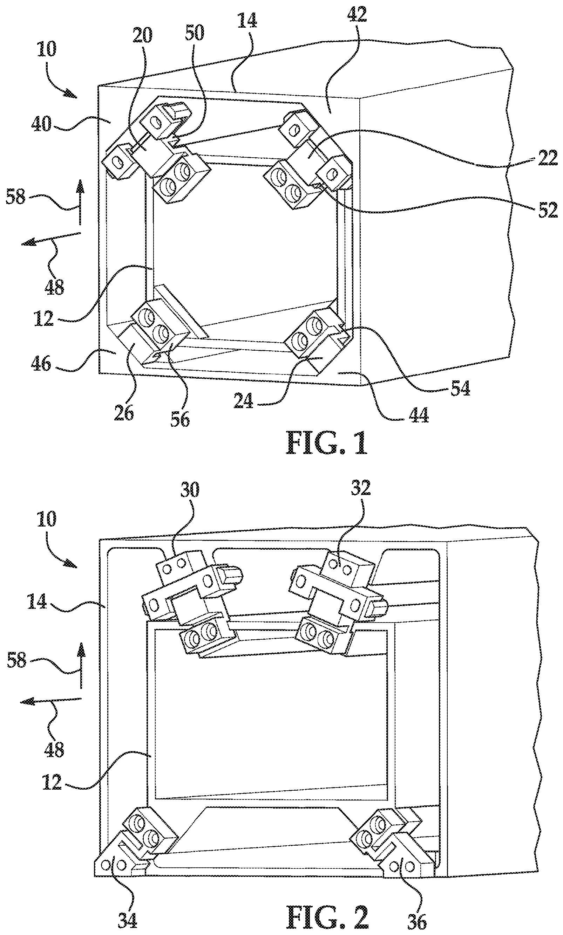

Figs. 1 and 2 show a vibration isolation system 10 that is used to isolate an inner object 12 from vibrations in an outer housing 14 that surrounds the inner object 12. Fig. 1 shows a forward portion of the system 10, with forward isolators 20, 22, 24, and 26. Fig. 2 shows an aft portion of the system 10, with aft isolators 30, 32, 34, and 36.

All of the isolators 20-36 aid in attenuating vibrations, with flexures of the isolators 20-36 helping to prevent vibrations and shocks at the outer housing 14 from being transmitted to the inner object 12. In addition the isolators 20-36 are configured to allow displacement of the inner object 12 relative to the outer housing 14, in both a longitudinal direction (or first direction) and in radial directions (or second directions) that are perpendicular to the longitudinal direction (first direction). This may be done (for example) to compensate for relative growth between the outer housing 14 and inner object 12 due to differences in thermal expansion. This difference will occur due to the outer housing 14 heating up during use faster than does the inner object 12. All of these aspects of the system 10 are described in greater detail below.

The forward isolators 20-26 may be fixedly attached to the inner object 12, such as at corners of the inner object 12. The outer ends of the isolators 20-26 rest on respective contact pads 40, 42, 44, and 46, with the isolators 20-26 free to slide in a longitudinal direction 48 along the contact pads 40-46. This allows for the system 10 to compensate for different amounts of expansion in the longitudinal direction 48, for instance caused by different amounts of heating of the outer housing 14 and the inner object 12 and the distance between mounting points of the forward and aft isolators. It will be appreciated that alternatively the forward isolators 20-26 may be fixedly attached to the outer housing 14, and free to slide in the longitudinal direction 48 relative to the inner object 12.

The forward isolators 20-26 have respective flexures 50, 52, 54, and 56. The flexures 50-56 are thinned S-shape portions of the isolators 20-26, where the isolators 20-26 preferentially flex to attenuate vibrations. In the illustrated embodiments the flexures 50-56 are oriented such that the middle portions of the S-shape flexures 50-56 extend in the longitudinal direction 48. However alternatively the flexures 50-56 may have other orientations.

In one example the flexures 50-56 have a thickness of 5 mm (0.2 inches), but a wide variety of other thicknesses are possible. The flexures may have a width of 25 mm (1 inch) and a height of 76 mm (3 inches), but again these are non-limiting example values, and a wide variety of alternative dimensions are possible depending on the required natural frequency of the system. In practice, the isolators attenuate vibrations above an isolation frequency.

The isolators 24 and 26 are single-piece isolators. These isolators are fixed and do not allow for expansion in the radial direction 58. In this description "radial direction" refers to any direction that is perpendicular to the longitudinal direction 48.

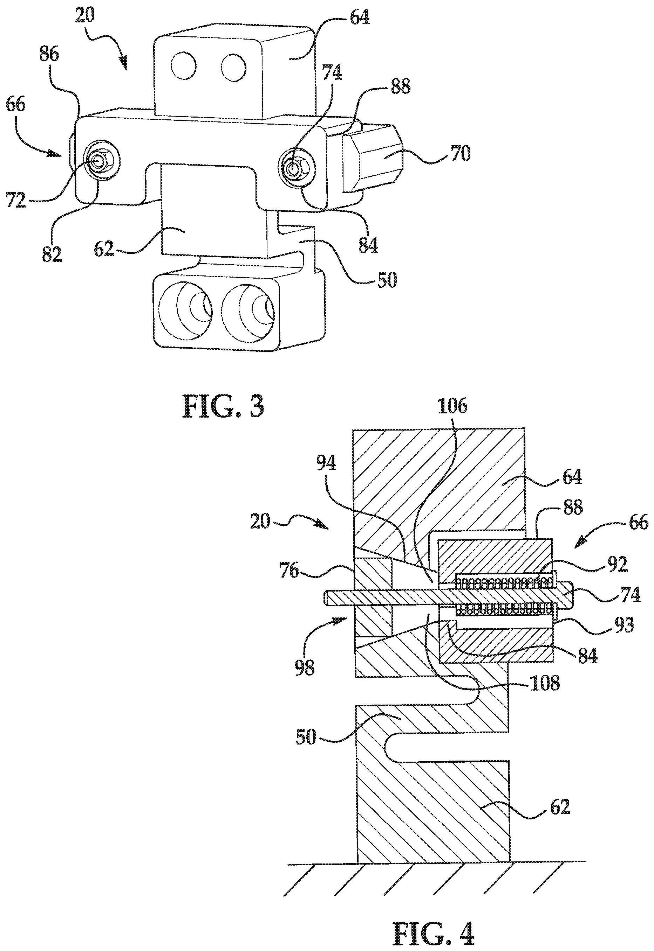

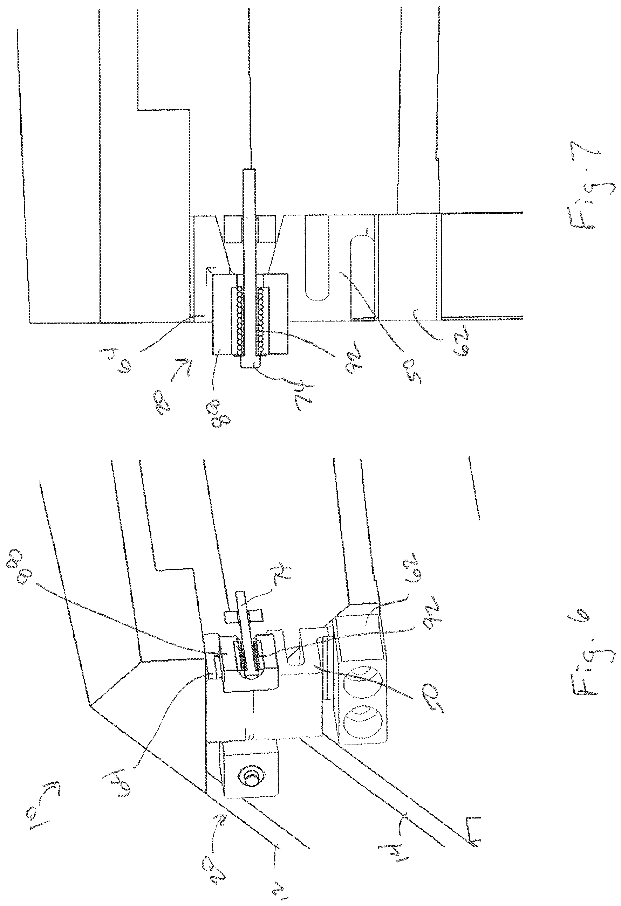

The other two forward isolators 20 and 22 are multi-part isolators that have wedge expanders or expansion mechanisms to allow extension in the radial direction 58. With reference now in addition to Figs. 3-7, details of the multi-part isolator 20 are described. The isolator shown in Fig. 3 is actually one of the aft isolators, but apart from a sliding connection at one end versus a fixed connection, the forward and aft multi-part isolators have identical configurations. The isolator 20 includes an inner isolator part 62 and an outer isolator part 64, with an expander or expansion mechanism 66 between the parts 62 and 64, for providing controlled expansion of the isolator 20 in the radial direction by moving the parts 62 and 64 apart.

The expansion mechanism (expander) 66 includes a wedge element or wedge part 70, and a pair of fasteners 72 and 74 that initially mechanically couple side flanges of the wedge element 70, such as a side flange 76, to the outer part 64. The fasteners 72 and 74 may be threaded fasteners such as bolts. The fasteners 72 and 74 pass through slotted holes 82 and 84 in side flanges 86 and 88 of the outer part 64. The fasteners 72 and 74 have springs around them, an example being a helical spring 92, which is located in a well 93 in the flange 88. The springs such as the spring 92 are preloaded so as to provide a force pulling a central wedge portion 94 of the wedge element 70 into a wedge-receiving channel 98 between the parts 62 and 64. The channel 98 is defined by respective facing sloped surfaces 102 and 104 of the parts 62 and 64. The central wedge portion 94 has a trapezoidal cross-section shape, with sloped side surfaces 106 and 108 that engage the respective sloped surfaces 102 and 104. The slope of the wedge portion 94 may be 15 degrees, or about 15 degrees, or between 10 and 20 degrees, to give non-limiting example values and ranges. Other angles may be used depending on the requirements for the system in operation.

Movement of the wedge portion 94 is constrained by the relative locations of the inner object 12 (Fig. 1) and the outer housing 14 (Fig. 1). Initially, prior to heating of the housing 14, the object 12 and the housing 14 are relatively close together, as shown in Fig. 4. In this condition the helical springs provide a force pulling the wedge portion 70 against the sloped surfaces 102 and 104. This produces a preload of the isolator 20 against the object 12 and the housing 14.

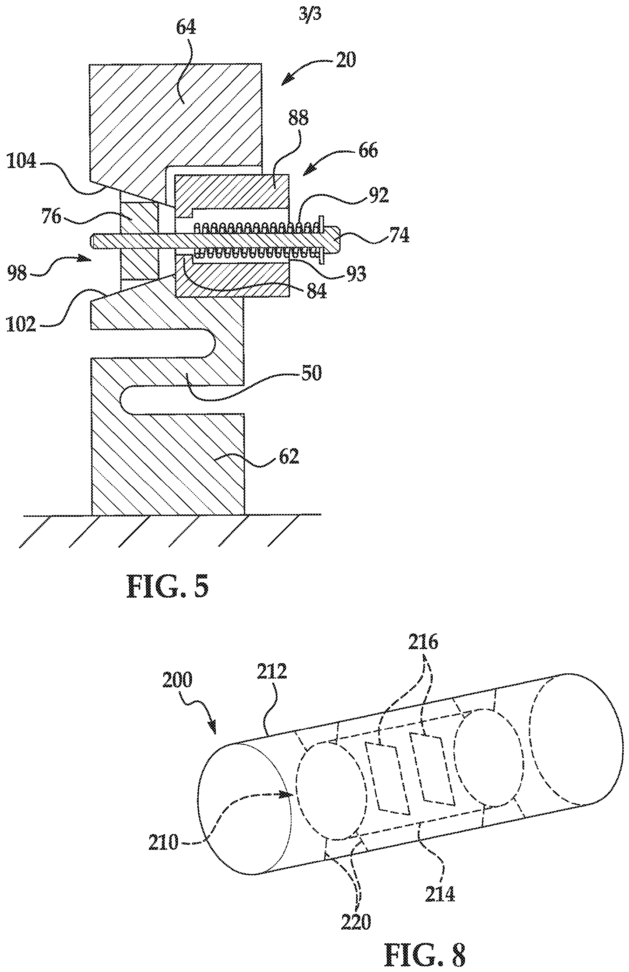

After the heating of the housing 14 (Fig. 1) the housing 14 expands, moving away from the inner object 12 (Fig. 1). This pulls the parts 62 and 64 away from another, with the wedge portion 70 pulled further inward into the channel 98 by the spring forces, producing the situation shown in Fig. 5. This maintains the preload provided by the isolator 20 against inner object 12 and the outer housing 14. In addition it allows the parts 62 and 64 to be solidly held together and to function essentially as a single piece, allowing the flexure 50 to continue to attenuate vibrations and shocks at a high frequency. It has been found that friction is sufficient to lock up the parts 62 and 64, to prevent even small outward movements of the wedge portion 94 as the wedge element 70 is drawn inward and held in place.

It will be appreciated that many variations are possible for the isolator 20, and the isolator 22, which has a similar configuration. For example the flexure 50 may be in either of the parts, and the wedge element may be mechanically coupled to either of the parts.

The parts 62 and 64 may be made of any of a variety of suitable materials, for example a nickel-chromium-based superalloy marketed as INCONEL 718. The wedge element 70 also may be made of any of a variety of suitable materials, one example of a suitable material being a nitrogen-strengthened stainless steel alloy marketed as NITRONIC 60. It is desirable for the material for the wedge element 70 to be selected so as to minimize, avoid, and/or mitigate wear.

The aft isolators 30-36 (Fig. 2) also include single-piece isolators, the isolators 34 and 36, and multi-piece isolators, the isolators 30 and 32. The isolators 30, 32, 34, and 36 have respective flexures 120, 122, 124, and 126. In the illustrated embodiment the flexures 120 and 122 are oriented in a longitudinal direction, and the flexures 124 and 126 are oriented in a circumferential direction, but other orientations may be used as alternatives. The multi-piece isolators 30 and 32 have configurations similar to those of the isolator 20, described above.

Together the forward isolators 20-26 and the aft isolators 30-36 damp vibrations and shocks between the outer housing 14 and the inner object 12. The sliding of the forward isolators 20-26 compensate for expansions in the longitudinal direction 48. The expansion of the multi-piece isolators 20, 22, 30, and 32 compensates for expansions in the radial direction 58.

The illustrated system 10 has four forward isolators and four aft isolators. Alternatively there may be a different number of isolators, such as three or more than four isolators in the forward or aft parts. Also alternatives are possible regarding which of the isolators are the forward isolators, and which are the aft isolators.

Fig. 8 shows one employment of a vibration isolation system such as that described above, with a missile 200 including a vibration isolation system 210 to damp shocks or vibrations of a fuselage 212, from a hardware mount 214 that is within the fuselage 212. The hardware mount 214 is used for mounting electronics devices 216, such as card with electronic elements. More broadly the mount 214 may be used to mount other types of hardware or devices to which it is desirable that vibrations or shocks not be transmitted.

The system 210 may include a number of isolators 220, which may be similar to the isolators described above with regard to the system 10 (Fig. 1). The missile 200 may be a supersonic or hypersonic missile, with the fuselage 212 heating up significantly during flight, for example with the fuselage 212 having a temperature rise of 556 to 667 degrees C (1000 to 1200 degrees F). This causes the fuselage 212 to expand significantly in longitudinal and radial directions relative to the hardware mount 214. The isolators may include single-piece and multi-part isolators, and fixed-position and slidable isolators to compensate for the expansion of the fuselage 212 due to its rise in temperature.

Although the invention has been shown and described with respect to a certain preferred embodiment or embodiments, it is obvious that equivalent alterations and modifications will occur to others skilled in the art upon the reading and understanding of this specification and the annexed drawings. In particular regard to the various functions performed by the above described elements (components, assemblies, devices, compositions, etc.), the terms (including a reference to a "means") used to describe such elements are intended to correspond, unless otherwise indicated, to any element which performs the specified function of the described element (i.e., that is functionally equivalent), even though not structurally equivalent to the disclosed structure which performs the function in the herein illustrated exemplary embodiment or embodiments of the invention. In addition, while a particular feature of the invention may have been described above with respect to only one or more of several illustrated embodiments, such feature may be combined with one or more other features of the other embodiments, as may be desired and advantageous for any given or particular application.

## Claims

1. A vibration isolator (20) comprising:
an inner isolator part (62);
an outer isolator part (64) comprising side flanges (86, 88), the side flanges defining a first slotted hole (82) and a second slotted hole (84);
a wedge element (70) comprising a central wedge portion (94) and side flanges (76); and
a pair of fasteners (72, 74);
wherein a first one of the pair of fasteners passes through the first slotted hole and a second one of the pair of fasteners passes through the second slotted hole to mechanically couple the side flanges of the wedge element to the side flanges of the outer isolator part;
wherein one of the inner isolator part and the outer isolator part has a flexure and the flexure is configured to act in series with the wedge element;
wherein a first spring (92) is positioned around the first one of the pair of fasteners and a second spring (92) is positioned around the second one of the pair of fasteners, the first and second springs being preloaded to provide a force pulling the central wedge portion of the wedge element into a wedge-receiving channel (98) between the inner isolator part and the outer isolator part;
wherein the inner isolator part and the outer isolator part comprise respective facing sloped surfaces (102, 104) that together define the wedge-receiving channel; and
wherein the central wedge portion has a trapezoidal cross-section with sloped side surfaces (106, 108) that engage the respective facing sloped surfaces of the inner and outer isolator parts.

2. The vibration isolator (20) of claim 1, wherein the central wedge portion (94) has a wedge angle of between 10 and 20 degrees.

3. A vibration isolation system (10) comprising:
an outer housing (14);
an inner object (12) within the outer housing; and
multiple isolators (20-36) between the inner object and the outer housing;
wherein at least two of the multiple isolators are vibration isolators (20) according to claim 1 or 2.

4. The vibration isolation system (10) of claim 3, wherein the multiple isolators include single-piece isolators (24, 26, 30-36).

5. The vibration isolation system (10) of claim 3 or 4, wherein the multiple isolators include isolators (20-26) that slide relative to one of the outer housing (14) or the inner object (12).

6. The vibration isolation system (10) of claim 5, wherein the isolators that slide are configured to slide in a first direction (48); and
wherein two of the isolators expand in a second direction that is perpendicular to the first direction.

7. The vibration isolation system (10) of claim 6, wherein the first direction is a longitudinal direction.

8. The vibration isolation system (10) of claim 5, wherein the isolators that slide are configured to slide against contact pads (40-46).

9. The vibration isolation system (10) of any of claims 3 to 8, wherein the flexures of the vibration isolators are S-shape flexures.

10. The vibration isolation system (10) of claim 9, wherein middle portions of the S-shape flexures have different orientations for one of the S-shape flexures than for another of the S-shape flexures.

11. The vibration isolation system (10) of any of claims 3 to 10, wherein the inner object is a hardware mount (214).

12. The vibration isolation system (10) of claim 11, further comprising equipment in the hardware mount.

13. The vibration isolation system (10) of claim 11, further comprising electronic cards, electronic devices (216), or electronic elements in the hardware mount.

14. The vibration isolation system (10) of any of claims 3 to 13, wherein the outer housing is part of a missile (200).

## Patentansprüche

1. Schwingungsisolator (20), umfassend:
ein inneres Isolatorteil (62);
ein äußeres Isolatorteil (64), umfassend Seitenflansche (86, 88), die Seitenflansche definierend ein erstes Langloch (82) und ein zweites Langloch (84);
ein Keilelement (70), umfassend einen zentralen Keilabschnitt (94) und Seitenflansche (76); und
ein Paar von Befestigungsmitteln (72, 74);
wobei ein erstes des Paars von Befestigungsmitteln durch das erste Langloch verläuft und ein zweites des Paars von Befestigungsmitteln durch das zweite Langloch verläuft, um die Seitenflansche des Keilelements mechanisch mit den Seitenflanschen des äußeren Isolatorteils zu koppeln;
wobei eines von dem inneren Isolatorteil und dem äußeren Isolatorteil eine Biegestruktur aufweist und die Biegestruktur ausgelegt ist, um in Reihe mit dem Keilelement zu wirken;
wobei eine erste Feder (92) um das erste des Paars von Befestigungsmitteln positioniert ist und eine zweite Feder (92) um das zweite des Paars von Befestigungsmitteln positioniert ist, wobei die erste und die zweite Feder vorgespannt sind, um eine Kraft bereitzustellen, die den zentralen Keilabschnitt des Keilelements in einen Keilaufnahmekanal (98) zwischen dem inneren Isolatorteil und dem äußeren Isolatorteil zieht;
wobei das innere Isolatorteil und das äußere Isolatorteil jeweilige einander zugewandte geneigte Oberflächen (102, 104) umfassen, die zusammen den Keilaufnahmekanal definieren; und wobei der zentrale Keilabschnitt einen trapezförmigen Querschnitt mit geneigten Seitenoberflächen (106, 108) aufweist, die mit den jeweiligen einander zugewandten geneigten Oberflächen des inneren und des äußeren Isolatorteils in Eingriff stehen.

2. Schwingungsisolator (20) nach Anspruch 1, wobei der zentrale Keilabschnitt (94) einen Keilwinkel zwischen 10 und 20 Grad aufweist.

3. Schwingungsisolationssystem (10), umfassend:
ein äußeres Gehäuse (14);
ein inneres Objekt (12) innerhalb des äußeren Gehäuses; und mehrere Isolatoren (20-36) zwischen dem inneren Objekt und dem äußeren Gehäuse;
wobei mindestens zwei der mehreren Isolatoren Schwingungsisolatoren (20) nach Anspruch 1 oder 2 sind.

4. Schwingungsisolationssystem (10) nach Anspruch 3, wobei die mehreren Isolatoren einstückige Isolatoren (24, 26, 30-36) beinhalten.

5. Schwingungsisolationssystem (10) nach Anspruch 3 oder 4, wobei die mehreren Isolatoren Isolatoren (20-26) beinhalten, die relativ zu einem von dem äußeren Gehäuse (14) oder dem inneren Objekt (12) gleiten.

6. Schwingungsisolationssystem (10) nach Anspruch 5, wobei die Isolatoren, die gleiten, ausgelegt sind, um in eine erste Richtung (48) zu gleiten; und
wobei sich zwei der Isolatoren in eine zweite Richtung ausdehnen, die senkrecht zu der ersten Richtung verläuft.

7. Schwingungsisolationssystem (10) nach Anspruch 6, wobei die erste Richtung eine Längsrichtung ist.

8. Schwingungsisolationssystem (10) nach Anspruch 5, wobei die Isolatoren, die gleiten, ausgelegt sind, um gegen Kontaktpads (40-46) zu gleiten.

9. Schwingungsisolationssystem (10) nach einem der Ansprüche 3 bis 8, wobei die Biegestrukturen der Schwingungsisolatoren S-förmige Biegestrukturen sind.

10. Schwingungsisolationssystem (10) nach Anspruch 9, wobei mittlere Abschnitte der S-förmigen Biegestrukturen bei einer der S-förmigen Biegestrukturen andere Orientierungen aufweisen als bei einer anderen der S-förmigen Biegestrukturen.

11. Schwingungsisolationssystem (10) nach einem der Ansprüche 3 bis 10, wobei das innere Objekt eine Hardwarehalterung (214) ist.

12. Schwingungsisolationssystem (10) nach Anspruch 11, ferner umfassend Ausrüstung in der Hardwarehalterung.

13. Schwingungsisolationssystem (10) nach Anspruch 11, ferner umfassend elektronische Karten, elektronische Vorrichtungen (216) oder elektronische Elemente in der Hardwarehalterung.

14. Schwingungsisolationssystem (10) nach einem der Ansprüche 3 bis 13, wobei das äußere Gehäuse Teil eines Flugkörpers (200) ist.

## Revendications

1. Isolateur antivibrations (20) comprenant :
une partie d'isolateur interne (62) ;
une partie d'isolateur externe (64) comprenant des brides latérales (86, 88), les brides latérales définissant un premier trou oblong (82) et un second trou oblong (84) ;
un élément de coin (70) comprenant une partie de coin centrale (94) et des brides latérales (76) ; et
une paire de fixations (72, 74) ;
dans lequel une première fixation de la paire de fixations passe à travers le premier trou oblong et une seconde fixation de la paire de fixations passe à travers le second trou oblong pour coupler mécaniquement les brides latérales de l'élément de coin aux brides latérales de la partie d'isolateur externe ;
dans lequel l'une de la partie d'isolateur interne et de la partie d'isolateur externe a une flexion et la flexion est configurée pour agir en série avec l'élément de coin ;
dans lequel un premier ressort (92) est positionné autour de la première fixation de la paire de fixations et un second ressort (92) est positionné autour de la seconde fixation de la paire de fixations, les premier et second ressorts étant préchargés pour fournir une force tirant la partie de coin centrale de l'élément de coin dans un canal de réception de coin (98) entre la partie d'isolateur interne et la partie d'isolateur externe ;
dans lequel la partie d'isolateur interne et la partie d'isolateur externe comprennent des surfaces inclinées en regard (102, 104) respectives qui définissent ensemble le canal de réception de coin ; et
dans lequel la partie de coin centrale a une section transversale trapézoïdale avec des surfaces latérales inclinées (106, 108) qui entrent en prise avec les surfaces inclinées en regard respectives des parties d'isolateur interne et externe.

2. Isolateur antivibrations (20) selon la revendication 1, dans lequel la partie de coin centrale (94) a un angle de coin compris entre 10 et 20 degrés.

3. Un système d'isolation antivibrations (10) comprenant :
un logement externe (14) ;
un objet interne (12) au sein du logement externe ; et
de multiples isolateurs (20-36) entre l'objet interne et le logement externe ;
dans lequel au moins deux des multiples isolateurs sont des isolateurs antivibrations (20) selon la revendication 1 ou 2.

4. Système d'isolation antivibrations (10) selon la revendication 3, dans lequel les multiples isolateurs comportent des isolateurs (24, 26, 30-36) monoblocs.

5. Système d'isolation antivibrations (10) selon la revendication 3 ou 4, dans lequel les multiples isolateurs comportent des isolateurs (20-26) qui coulissent par rapport à l'un du logement externe (14) ou de l'objet interne (12).

6. Système d'isolation antivibrations (10) selon la revendication 5, dans lequel les isolateurs qui coulissent sont configurés pour coulisser dans une première direction (48) ; et dans lequel deux des isolateurs s'étendent dans une seconde direction perpendiculaire à la première direction.

7. Système d'isolation antivibrations (10) selon la revendication 6, dans lequel la première direction est une direction longitudinale.

8. Système d'isolation antivibrations (10) selon la revendication 5, dans lequel les isolateurs qui coulissent sont configurés pour coulisser contre des coussinets de contact (40-46).

9. Système d'isolation antivibrations (10) selon l'une quelconque des revendications 3 à 8, dans lequel les flexions des isolateurs antivibrations sont des flexions en forme de S.

10. Système d'isolation antivibrations (10) selon la revendication 9, dans lequel les parties médianes des flexions en forme de S ont des orientations différentes pour l'une des flexions en forme de S que pour une autre des flexions en forme de S.

11. Système d'isolation antivibrations (10) selon l'une quelconque des revendications 3 à 10, dans lequel l'objet interne est un support matériel (214).

12. Système d'isolation antivibrations (10) selon la revendication 11, comprenant en outre un équipement dans le support matériel.

13. Système d'isolation antivibrations (10) selon la revendication 11, comprenant en outre des cartes électroniques, des dispositifs électroniques (216), ou des éléments électroniques dans le support matériel.

14. Système d'isolation antivibrations (10) selon l'une quelconque des revendications 3 à 13, dans lequel le logement externe fait partie d'un missile (200).
